# EUROPÄISCHE PATENTANMELDUNG

(11) **EP 0 523 547 A2**
(43) Veröffentlichungstag der Anmeldung: **20.01.1993**
(21) Anmeldenummer: 92111676.0
(22) Anmeldetag: 09.07.1992
(51) Int. Cl.: H01L 21/48, H01L 21/60

(54) **Chemisch vernickeltes DCB-Substrat und Verfahren, um es mit dünnen Drähten zu verbinden**

(30) Priorität: 18.07.1991 DE 4123911
(71) Anmelder: DODUCO GMBH + Co Dr. Eugen Dürrwächter, D-75181 Pforzheim (DE)
(72) Erfinder: Exel, Karl, Dr. Dipl.-Phys., W-6149 Rimbach (DE); Laipple, Peter, Dipl.-Ing., W-7540 Neuenbürg (DE)
(74) Vertreter: Twelmeier, Ulrich, Dipl.Phys.

(57) **Zusammenfassung**

Verfahren zum Verbinden von chemisch vernikkelten DCB-Substraten mit dünnen Drähten aus Aluminium, ggfs. mit einem geringen Zusatz von Silizium, durch Dünndraht-Bonden. Um die Qualität der Drahtbond-Verbindungen zu verbessern, wird die noch nicht vernickelte Kupferoberfläche der DCB-Substrate nach dem direkten Verbinden des Kupfers mit einem keramischen Träger geglättet, bis ihre Rauhtiefe R_{z} < 5 um ist. Die geglättete Kupferoberfläche wird chemisch vernickelt und danach durch das Dünndraht-Bonden mit den Drähten verbunden.

## Beschreibung

Die Erfindung geht aus von einem Verfahren mit den im Oberbegriff des Anspruchs 1 angegebenen Merkmalen und von einem Substrat mit den im Oberbegriff des Anspruchs 7 angegebenen Merkmalen.

DCB-Substrate bestehen aus einem keramischen Träger, im allgemeinen in Form einer Platte oder Scheibe, welcher unmittelbar, ohne Zuhilfenahme eines Lotmetalls, mit einer oder mehreren Kupferplatten oder Kupferfolien fest verbunden ist. Diese Art der Verbindungstechnik wird als Direct-Copper-Bonding bezeichnet. Die feste Verbindung zwischen dem Kupfer und der Keramikoberfläche wird durch eine Verfahrensführung erreicht, bei welcher im Grenzbereich zwischen dem Kupfer und der Keramikoberfläche zeitweise ein schmelzflüssiges Kupfer-Kupferoxid-Eutektikum gebildet wird, welches die Keramikoberfläche benetzt. DCB-Substrate sind bekannt aus der DE-37 28 096 und dienen beispielsweise als Träger für Leistungshalbleiter, deren Verlustwärme sie aufnehmen und ableiten sollen. In diesem Zusammenhang stellt sich die Aufgabe, elektrische Bauelemente durch dünne Drähte mit vernickelten DCB-Substraten zu verbinden. Eine hierfür bekannte Technik ist das Dünndraht-Bonden. Beim Dünndraht-Bonden werden dünne Drähte, die im allgemeinen nicht dicker als 50 um, vorzugsweise 15 bis 35 um dick sind, durch ein mit Ultraschall unterstütztes Reibschweißen mit dem Substrat verbunden. Diese Verbindung muss sehr zuverlässig sein. Üblicherweise strebt man in der Fertigung von Halbleiterbauelementen Ausfallquoten im ppm-Bereich an. Beim Dünndraht-Bonden von Drähten auf DCB-Substrate treten aber Ausfallquoten im Prozentbereich auf.

Der vorliegenden Erfindung liegt deshalb die Aufgabe zugrunde, die Voraussetzung dafür zu schaffen, dass dünne Drähte aus Aluminium, ggfs. mit einem geringen Zusatz von Silizium, mit größerer Zuverlässigkeit durch Dünndraht-Bonden fest mit chemisch vernickelten DCB-Substraten verbunden werden können.

Diese Aufgabe wird gelöst durch DCB-Substrate mit den im Anspruch 1 angegebenen Merkmalen sowie durch ein Verbindungsverfahren mit den im Anspruch 7 angegebenen Merkmalen. Vorteilhafte Weiterbildungen der Erfindung sind Gegenstand der abhängigen Ansprüche.

Die Erfinder haben herausgefunden, dass die Zuverlässigkeit der Bond-Verbindung von dünnen Drähten aus Aluminium, welche ggfs. einen geringen Zusatz von Silizium, im allgemeinen 1 Gew.-% Silizium, mit einem chemisch vernickelten DCB-Substrat wesentlich verbessert werden kann, wenn die Rauhtiefe R_{z} der Kupferschicht unter der Nikkelschicht kleiner als 5 um, vorzugsweise kleiner als 3 um ist.

Als Kennzahl für die Rauhigkeit ist die Rauhtiefe R_{z} angegeben. Sie ist definiert als Mittelwert der Rauhtiefe an fünf aufeinanderfolgenden Meßstellen auf der untersuchten Oberfläche.

Die beanspruchte geringe Rauhheit ergibt sich nicht von selbst. Selbst dann, wenn man beim Herstellen von DCB-Substraten von Kupferfolien oder Kupferplatten ausgeht, deren Rauhtiefe R_{z} kleiner als 5 um ist, hat die Kupferoberfläche nach dem Direct-Copper-Bonding-Prozess eine größere Rauhtiefe, weil bei den beim Direct-Copper-Bonding erreichten hohen Temperaturen (das Kupfer-Kupferoxid-Eutektikum schmilzt bei ca. 1065°C) ein starkes Kornwachstum im Kupfer stattfindet, welches in der Kupferoberfläche zur Ausbildung von Korngrenzgräben führt.

Erfindungsgemäss ist nun vorgesehen, die durch das Direct-Copper-Bonding hervorgerufene Aufrauhung der Kupferoberfläche zu glätten und die Rauhtiefe der Kupferoberfläche auf R_{z} < 5 um, vorzugsweise R_{z} <3 um, zu begrenzen, indem man die Kupferoberfläche entsprechend mechanisch bearbeitet, z.B. durch Polieren oder Bürsten oder Läppen, wobei letzteres besonders geeignet ist. Danach wird dann die Kupferoberfläche chemisch vernickelt. Das chemische Abscheideverfahren hat die Eigenart, das Profil, auf welcher die Abscheidung stattfindet, annähernd im Maßstab 1:1 nachzubilden. Deshalb hat die chemisch abgeschiedene Nickelschicht annähernd dasselbe Oberflächenprofil und eine nur geringfügig kleinere Rauhtiefe als die Kupferoberfläche, auf welcher sie abgeschieden ist.

Die Nickelschicht sollte mindestens 1 um dick sein. Bei dünneren Nickelschichten ist die Gefahr zu groß, dass die dünnen Drähte beim Bonden durch die Nickelschicht hindurchgedrückt werden und Kontakt mit der darunterliegenden Kupferschicht erhalten, welche für das Bonden weniger geeignet ist. Mit zunehmender Dicke der Nickelschicht steigt die Zuverlässigkeit der durch das Dünndraht-Bonden erzielten Verbindung zunächst stärker und dann schwächer an. Nickelschichten zu verwenden, die dicker als 20 um sind, ist wenig sinnvoll, weil damit keine wesentliche Verbesserung mehr erzielt wird und die Abscheidung der Nickelschicht zu lange dauert. Der bevorzugte Bereich für die Nickelschichtdicke liegt zwischen 7 und 15 um.

Mit Vorteil kann die Nickelschicht vor dem Dünndraht-Bonden mit einer hauchdünnen Goldschicht ("flash") überzogen werden, um sie vor Oxidation zu schützen.

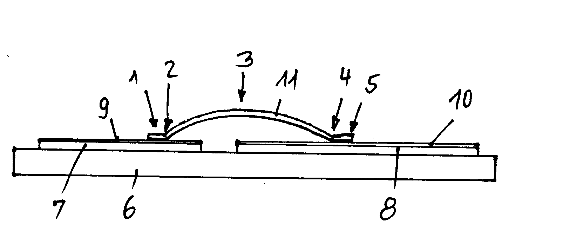

Die beigefügte Zeichnung zeigt ein DGB-Substrat in einer Seitenansicht. Das DCB-Substrat hat als Träger eine keramische Platte 6, beispielsweise aus Aluminiumoxid, auf welcher durch Direct-Copper-Bonding zwei Kupferplatten 7 und 8 mit Abstand nebeneinander befestigt sind. Beide Kupferplatten 7 und 8 sind auf ihrer Oberseite chemisch vernickelt. Auf die Nickelschichten 9 und 10 ist ein dünner Draht 11 aus Aluminium mit 1 % Silizium aufgebondet. Das Drahtbonden wird mit Hilfe eines nadelförmigen Bond-Werkzeuges durch Reibschweißen mit Ultraschallunterstützung durchgegeführt. Zwischen den Bondstellen 1 und 5 auf den beiden Nickelschichten 9 und 10 ist ein Drahtabschnitt 3 gespannt. Am Übergang des gespannten Drahtabschnittes 3 zu den Bondstellen 1 und 5 befinden sich vom Bond-Werkzeug verursachte Quetschstellen 2 und 4, bei denen es sich um die schwächsten Stellen des gebondeten Drahtes handeln sollte: Wird Zug auf den Draht 11 ausgeübt, sollte der Draht als erstes an einer der gequetschten Stellen 2 oder 4 reißen, nicht aber in dem dazwischen gespannten Abschnitt 3, und er sollte nicht an den gebondeten Stellen 1 und 5 abheben. Dies wurde in den folgenden Beispielen überprüft:

### Vergleichsbeispiel 1:

Die Kupferplatten 7 und 8 hatten nach dem Direct-Copper-Bonding eine Rauhtiefe R_{z} = 6 um. Sie wurden, ohne sie zuvor zu glätten, 3 um dick chemisch vernickelt und anschließend ein AISiI-Draht mit 50 um Durchmesser mit beiden Enden auf die vernickelten Kupferplatten 7 und 8 gebondet.

Bei 200 so aufgebondeten Drähten 11 wurde deren Reißfestigkeit bzw. die Festigkeit der Bond-verbindung überprüft. In 7 Fällen kam es zum Abheben des Drahtes 11 an einer seiner Bondstellen 1 bzw. 5, in den verbleibenden 193 Fällen kam es zum Abreißen des Drahtes an einer seiner Quetschstellen 2 bzw. 4. In 7 Fällen war die Bond-Verbindung also schwächer als die Quetschstellen 2 und 4.

### Vergleichsbeispiel 2:

Es wurden Drähte aufgebondet wie im Vergleichsbeispiel 1, jedoch wurden die Substrate vor dem Dünndraht-Bonden 10 min. lang in inerter Atmosphäre bei 400 C getempert um die Nickelschichten 9 und 10 zu härten (stromlos abgeschiedenes Nickel enthält üblicherweise Phosphor; beim Erwärmen kommt es zur Ausscheidung von Ni₃P). Dabei wird eine Härtesteigerung auf eine Vickers-Mikrohärte (HV 0,01) von ca. 1000 kp/mm² erreicht. Die an wiederum 200 aufgebondeten Drähten durchgeführte Reißprüfung ergibt, dass 45 Drähte 11 an einer der beiden Bondstellen 1 bzw. 5 abheben, wohingegen 155 Drähte an einer der beiden Quetschstellen 2 bzw. 4 abreißen. Die Härtesteigerung der Nickeloberfläche hat mithin nicht zu einer Verbesserung, sondern zu einer Verschlechterung der Qualität der Bond-Verbindung geführt.

### Vergleichsbeispiel 3:

Die DCB-Substrate wurden 10 um dick chemisch mit Nickel beschichtet. Im übrigen wurde wie im 1 Vergleichsbeispiel vorgegangen. Von 200 überprüften Drähten 11 lösten sich 8 an einer der Bondstellen 1 bzw. 5 ab, die restlichen 192 hingegen an einer der Quetschstellen 2 und 4.

### Vergleichsbeispiel 4:

Die DCB-Substrate wurden 10 um dick chemisch vernickelt. Im übrigen wurde vorgegangen wie im Vergleichsbeispiel 2. Von 200 überprüften Drähten lösten sich 3 an einer der Bondstellen 1 und 5 ab, 195 Drähte rissen an einer der Quetschstellen 2 und 4 ab und 2 Drähte brachen in ihrem mittleren Abschnitt 3.

Die Vergleichsbeispiele 3 und 4 zeigen, dass mit DCB-Substraten, deren Nickelschicht nicht wärmebehandelt wird, durch eine Erhöhung der Nikkelschichtdicke keine signifikante Änderung der Ausfallquote erreicht wird. Bei den DCB-Substraten mit wärmebehandelter Nickelschicht ist eine Verringerung der Ausfallquote bei Erhöhung der Schichtdicke von 3 um auf 10 um festzustellen.

### Beispiel 1:

Die Kupferplatten 7 und 8 werden nach dem Direct-Copper-Bonding, aber vor dem Vernickeln geläppt und haben danach eine Rauhtiefe R_{z} = 2,5 um. Anschließend werden sie 10 um dick chemisch vernickelt. Im übrigen wird vorgegangen wie im Vergleichsbeispiel 1.

Beim Reißtest an 200 aufgebondeten Drähten 11 zeigt sich, dass alle Drähte an einer der Quetschstellen 2 und 4 abreißen, aber keiner an einer der Bondstellen 1 oder 5 abhebt. Die Ausfallquote ist also gleich null.

### Beispiel 2:

Die Nickelschicht wird wärmebehandelt wie im Vergleichsbeispiel 2. Im übrigen wird vorgegangen wie im Beispiel 1. Der Reißtest an 200 Drähten 11 zeigt, dass alle Drähte an einer der Quetschstellen 2 und 4 abreißen, aber keiner an einer der beiden Bondstellen 1 oder 2 abhebt. Die Ausfallquote ist also auch in diesem Beispiel gleich null.

Die Zuverlässigkeit der Drahtbond-Verbindungen hat sich durch Anwendung der Erfindung mithin markant erhöht, unabhängig davon,ob die Nikkelschicht durch Wärmebehandlung gehärtet wurde oder nicht.

## Patentansprüche

1. Verfahren zum Verbinden von chemisch vernickelten DCB-Substraten mit dünnen Drähten aus Aluminium, ggfs. mit einem geringen Zusatz von Silizium, durch Dünndraht-Bonden, dadurch gekennzeichnet, dass die noch nicht vernickelte Kupferoberfläche nach dem direkten Verbinden des Kupfers mit einem keramischen Träger geglättet wird, bis ihre Rauhtiefe R_{z} <5 um ist, und dass die geglättete Kupferoberfläche chemisch vernickelt und danach durch Dünndraht-Bonden mit den Drähten verbunden wird.

2. Verfahren nach Anspruch 1, dadurch gekennzeichnet, dass die Kupferoberfläche geglättet wird, bis sie eine Rauhtiefe R_{z} < 3 um hat.

3. Verfahren nach Anspruch 1 oder 2, dadurch gekennzeichnet, dass die Kupferoberfläche 7 bis 15 um dick chemisch vernickelt wird.

4. Verfahren nach einem der Ansprüche 1 bis 3, dadurch gekennzeichnet, dass die Kupferoberfläche durch Läppen geglättet wird.

5. Verfahren nach einem der vorstehenden Ansprüche, dadurch gekennzeichnet, dass die Nickeloberfläche hauchvergoldet wird.

6. Chemisch vernickeltes DCB-Substrat, welches durch Dünndraht-Bonden mit dünnen Drähten aus Aluminium, ggfs. mit einem geringen Zusatz von Silizium, verbunden werden soll, dadurch gekennzeichnet, dass die Nickelschicht (9, 10) eine Rauhtiefe R_{z} < 4 um hat.

7. Substrat nach Anspruch 6, dadurch gekennzeichnet, dass die Nickelschicht (9, 10) 7 bis 15 um dick ist.

8. Substrat nach Anspruch 6 oder 7, dadurch gekennzeichnet, dass die Rauhtiefe der Nikkelschicht R_{z} < 2,5 um ist.

9. Substrat nach einem der Ansprüche 6 bis 8, dadurch gekennzeichnet, dass sich auf der Nickelschicht (9, 10) eine hauchdünne, größenordnungsmässig 0,1 um dicke Goldschicht ("flash") befindet.
